**Europäisches Patentamt**

**European Patent Office**

**Office européen des brevets**

(11) Veröffentlichungsnummer: **0 152 093**
**A2**

## (12) EUROPÄISCHE PATENTANMELDUNG

(21) Anmeldenummer: **85101473.8**

(22) Anmeldetag: **12.02.85**

(51) Int. Cl.⁴: **H 05 K 7/20**

(30) Priorität: **15.02.84 DE 3405243**

(43) Veröffentlichungstag der Anmeldung:
**21.08.85 Patentblatt 85/34**

(84) Benannte Vertragsstaaten:
**AT BE CH FR GB IT LI LU NL SE**

(71) Anmelder: **Autz + Herrmann Metallwaren- und
Maschinenfabrik
Karl-Benz-Strasse 10-12
D-6900 Heidelberg1(DE)**

(72) Erfinder: **Reinhard, Heinrich
Hans-Pfitzner-Strasse 28
D-6905 Schriesheim(DE)**

(74) Vertreter: **Rüger, Rudolf, Dr.-Ing. et al,
Webergasse 3 Postfach 348
D-7300 Esslingen/Neckar(DE)**

(54) **Einschub-Kühlgerät für Schaltschränke.**

(57) Ein Einschub-Kühlgerät für zur Aufnahme von Modul-Einschüben eingerichtete Schaltschränke ist mit einem im wesentlichen parallelflächig begrenzten Einschubgehäuse (1) ausgebildet, das einen Außenluftauslaß (11) und an seiner Vorderseite einen Außenlufteinlaß (10) aufweist und in dem eine von einem Innenluftstrom und einem Außenluftstrom durchströmte Wärmetauschereinrichtung angeordnet ist.

Um bei staubdicht abgeschlossenen Schaltschränken eine einwandfreie Wärmeabfuhr in unmittelbarer Nähe der jeweiligen Wärmequellen zu gewährleisten, ist die Anordnung derart getroffen, daß der Innen- und der Außenluftstrom in dem Einschubgehäuse (1) durch einen gemeinsamen Wärmetauscher geführt sind, der in Gestalt eines Plattenpaketes (12) ausgebildet ist, das im wesentlichen der Einschubhöhe entsprechende Höhenabmessungen aufweist, wobei in dem Einschubgehäuse (1) seitlich des Plattenpaketes (12) dem Innenluftstrom zugeordnete Luftkanäle (28a, 28b, 30a, 30b) angeordnet sind, die über wahlweise benutzbare Gehäuseöffnungen (41, 42) mit dem Schaltschrankinneren in Verbindung setzbar sind.

./...

Croydon Printing Company Ltd.

EP 0 152 093 A2

Fig. 5

0152093

- 1 -

Einschub-Kühlgerät für Schaltschränke

Die Erfindung betrifft ein Einschub-Kühlgerät für/zur Aufnahme von Modul-Einschüben eingerichtete Schaltschränke, mit einem im wesentlichen parallelflächig begrenzten Einschubgehäuse, das einen Außenluftauslaß und an seiner Vorderseite einen Außenlufteinlaß aufweist, und in dem eine von einem Innenluftstrom und einem Außenluftstrom durchströmte Wärmetauschereinrichtung angeordnet ist, wobei der Innen- und der Außenluftstrom in dem Einschubgehäuse voneinander getrennt geführt und beiden Luftströmen in dem Einschubgehäuse untergebrachte Gebläse zugeordnet sind.

Um die von den im Schaltschrankinneren untergebrachten elektrischen Schaltelementen und Geräten abgegebene Verlustwärme abzuführen, ist es in der Praxis bekannt, bei zur Aufnahme von Modul-Einschüben, bspw. 19"-Einschüben, eingerichteten Schaltschränken Einschub-Kühlgeräte zu benutzen, die ein kompressorbetriebenes Kühlaggregat enthalten, das in einem dem jeweils benutzten Modul entsprechenden, bspw. 19"-Einschubgehäuse, angeordnet ist. Das Einschubgehäuse ist dabei durch eine schrägverlaufende Trennwand in zwei Kammern unterteilt, von denen jede einen Wärmetauscher des Kühlaggregates enthält, der in der einen Kammer von einem im Schaltschrankinneren im Kreislauf geführten Innenluftstrom und in der anderen Kammer von einem Außenluftstrom durchströmt ist. Mit Rücksicht auf das beträchtliche Gewicht und die Betriebsweise des Kühlaggregates muß ein solches Einschub-Klimagerät in der Regel am Boden des Schaltschrankes angeordnet werden. Die Ein- und Auslaßöffnungen für den Innenluftstrom sind deshalb nebeneinanderliegend in der Deckwand des Einschubgehäuses angeordnet, während der Außenluftstrom durch einen Lufteinlaß an der Vorderwand des Einschubgehäuses eintretend die zugeordnete Kammer des Einschubgehäuses über die ganze Gehäusetiefe durchströmt und aus dem Gehäuse durch einen an der Gehäuserückseite angeordneten Luftauslaß austritt.

Diese Luftführung hat zur Folge, daß im Innenluftkreislauf die gesamte Gehäuseluft umgewälzt werden muß, wobei die von in dem Schaltschrank weiter oben angeordneten Wärmequellen herrührende Verlustwärme entsprechend weit nach unten transportiert werden muß. Damit kann in dem Schaltschrank ein unerwünscht großes Temperaturgefälle von oben nach unten auftreten, abgesehen davon, daß die Leistung des Kühlaggregates groß bemessen werden muß. Die an der Schaltschrankrückseite austretende Außenluft macht schließlich ein Aufstellen des Schaltschrankes unmittelbar an einer Wand oder dergl. unmöglich, ohne daß besondere Vorkehrungen für die Luftführung getroffen werden.

Daneben sind in der Praxis auch sogenannte 19"-Lüftereinschübe gebräuchlich, die ebenfalls ein Modul-Einschubgehäuse aufweisen und die in beliebiger Höhe in dem Schaltschrank angeordnet werden können. Ein solcher Lüftereinschub enthält ein oder mehrere Gebläse und weist an der Gehäusevorderseite eine Lufteinlaßöffnung auf, durch die Außenluft angesaugt und unmittelbar in das Schaltschrankinnere gefördert wird, von wo aus die Luft durch geeignete Austrittsöffnungen abströmt. Um eine Verschmutzung der in dem Schaltschrank untergebrachten Bauelemente zu verhüten, muß die von außen angesaugte kalte Luft vor dem Eintritt in den Schaltschrank gefiltert werden. Zu diesem Zwecke sind in dem Lüftereinschub entsprechende Luftfilter vorgesehen, die in Gestalt einer Filtermatte oder Filterpatrone ausgebildet sein können. Diese Luftfilter müssen regelmäßig überwacht und ausgewechselt werden, was umständlich und aufwendig ist. Trotzdem ist ein absolut staubdichter Abschluß des Gehäuseinnenraums gegen die Außenwelt nicht möglich.

Aufgabe der Erfindung ist es deshalb, ein Einschub-Kühlgerät für zur Aufnahme von Modul-Einschüben eingerichtete Schaltschränke zu schaffen, das bei staubdicht abgeschlossenen Schaltschränken eine einwandfreie Wärmeabfuhr in unmittelbarer Nähe der jeweiligen Wärmequellen gewährleistet.

Zur Lösung dieser Aufgabe ist das eingangs genannte Einschub-Kühlgerät erfindungsgemäß dadurch gekennzeichnet, daß der Innen- und der Außenluftstrom in dem Einschubgehäuse durch einen gemeinsamen Wärmetauscher geführt sind, der aus einer Anzahl zu einem abgeschlossenen Plattenpaket zusammengefügter gleicher Platten mit hochgebogenen seitlichen Rändern und einem an der Stirnseite hochgebogenen Rand besteht, zwischen denen abwechselnd
von der Innen- und der Außenluft durchströmte
flache Kanäle begrenzt sind, daß das Plattenpaket
im wesentlichen der Einschubhöhe entsprechende
Höhenabmessungen aufweist und in dem Einschubgehäuse seitlich des Plattenpaketes dem Innenluftstrom
zugeordnete Luftkanäle angeordnet sind, die über
wahlweise benutzbare Gehäuseöffnungen mit dem Schaltschrankinneren in Verbindung setzbar sind.

Dadurch, daß der Innen- und der Außenluftstrom
durch den als Plattenpaket ausgebildeten Wärmetauscher voneinander vollständig getrennt sind,
ist eine Verschmutzung des Schaltschrankinnenraumes
durch von dem Außenluftstrom mitgeführte Verunreinigungen ausgeschlossen. Durch entsprechende
Wahl der dem Innenluftstrom zugeordneten Gehäuseöffnungen kann die für eine wirksame Wärmeabfuhr
unmittelbar am Ort der Wärmequelle zweckmäßigste
Luftführung des Innenluftstromes eingestellt werden,
wobei das Einschub-Kühlgerät in jeder zweckentsprechenden Höhe in dem Schaltschrank angeordnet
werden kann. Da das Plattenpaket eine optimale
Ausnutzung des durch das Modul-Einschubgehäuse
vorgegebenen Raumes bewirkt, können mit verhältnismäßig geringen Luftgeschwindigkeiten große
Wärmemengen aus dem Schaltschrank abgeführt werden.

Dabei ist es zweckmäßig, wenn das Plattenpaket in
das Einschubgehäuse lösbar eingesetzt ist, so daß insbesondere die von dem Außenluftstrom beaufschlagten Kanäle erforderlichenfalls von Zeit zu Zeit gereinigt werden können, ohne daß eine umständliche Demontage oder schwierig durchzuführende Reinigungsarbeiten erforderlich wären. Die Notwendigkeit, betriebsmäßig ein Filter für die Außenluft zu verwenden, entfällt; ein solches Filter ist nur dann angezeigt, wenn der Schaltschrank in einer besonders staubigen oder sonst verunreinigten Umgebung steht.

Vorteilhaft ist es, wenn an der Vorderseite des Einschubgehäuses eine Einlaß- und eine Auslaßöffnung für den Außenluftstrom nebeneinanderliegend angeordnet sind, die jeweils abgedichtet mit entsprechenden Kanälen des Plattenpaketes abgedichtet verbunden sind. Damit kann der mit einem solchen Einschub-Kühlgerät ausgerüstete Schaltschrank mit seiner Rückseite unmittelbar an einer Wand oder dergl. anliegend aufgestellt werden, ohne daß zusätzliche äußere Luftführungskanäle erforderlich wären. Dabei ist es vorteilhaft, wenn auf das Einschubgehäuse im Bereiche der Einlaß- und/oder Auslaßöffnung jeweils eine verstellbare Luftleiteinrichtung aufgesetzt ist, durch die die zu- bzw. abströmende Außenluft wahlweise in eine gewünschte seitliche Richtung ablenkbar ist. Diese Luftleiteinrichtung kann eine drehbar gelagerte, die jeweilige Öffnung überdeckende Jalousie sein. Durch entsprechende Einstellung der Luftleiteinrichtung kann die Luftströmung an der Einschubgehäusevorderseite nach oben oder unten oder seitwärts gerichtet werden, wobei auch der zu- und der abströmenden Außenluft unterschiedliche Strömungsrichtungen gegeben werden können.

Eine ausgezeichnete Wärmeabfuhr ergibt sich, wenn durch entsprechende Ausbildung der Kanäle in dem Plattenpaket der Außenluftstrom im wesentlichen U-förmig zwischen der Einlaß- und der Auslaßöffnung verlaufend geführt ist und der Innenluft- strom in zwei getrennte Teilluftströme aufgeteilt ist, von denen jedem ein eigenes Gebläse zugeordnet ist. Die beiden Innen-Teilluftströme ermöglichen eine noch genauere Abstimmung der Luftführung im Schaltschrankinneren an die Anordnung der einzelnen Wärmequellen, mit dem Ergebnis, daß die abzuführende Wärme über besonders kurze Wegstrecken in dem jeweiligen Teilluftstrom transportiert werden muß.

Dabei kann die Anordnung derart getroffen sein, daß die beiden Teilluftströme nebeneinander verlaufend stirnseitig in zugeordnete Kanäle des Plattenpaktes eintretend oder aus diesem austretend geführt sind und ihnen an gegenüberliegenden Seiten des Plattenpaketes angeordnete Luftaus- bzw. -einläße zugeordnet sind, die in Luftkanäle des Einschubgehäuses münden. Die gegebenenfalls insbesondere verstellbare Luftumlenkeinrichtungen enthaltenden Luftkanäle können beidseitig des Plattenpaketes liegend angeordnet sein, wobei die zugeordneten Gehäuseöffnungen in der Ober-, Unter- oder Seitenwand des Einschubge- häuses wahlweise verschließbar ausgebildet sind. Da die Luftkanäle seitlich des Plattenpaketes vorgesehen sind, wird die kritische Höhe des Einschubgehäuses kleingehalten, während die für die jeweilige Luftführung zweckmäßigen Gehäuseöffnungen im Hinblick auf die Verhältnisse des Einzelfalles ausgewählt werden können.

Aus ähnlichen Gründen ist es auch vorteilhaft, wenn dem Plattenpaket in den Einschubgehäuse stirnseitig von den Teilluftströmen durchströmte Luftkanäle vorgeschaltet sind und die zugeordneten Gehäuseöffnungen in der Ober-, Unter- oder Stirnwand des Einschubgehäuses wahlweise verschließbar ausgebildet sind.

Konstruktiv kann dabei das Einschub-Kühlgerät derart ausgebildet sein, daß in dem Einschubgehäuse durch eine Luftdurchlässe aufweisende Trennwand eine die Luftkanäle bildende unterteilte Kammer abgeteilt ist, in der die den Teilluftströmen zugeordneten Gebläse angeordnet sind und die durch einen Gehäuseöffnungen enthaltenden lösbaren Deckel abgeschlossen ist. Dabei kann das Plattenpaket zwischen der Trennwand und der Vorderwand und/oder einer zweiten Trennwand des Einschubgehäuses stirnseitig jeweils abgedichtet angeschlossen gehaltert sein, was den Vorteil mit sich bringt, daß das Plattenpaket, bspw. zu Reinigungszwecken, in sehr einfacher Weise aus dem Einschubgehäuse entnommen werden kann, während die Gebläse mit ihrer festverdrahteten Stromversorgung unverändert in dem Einschubgehäuse verbleiben. Dazu ist es vorteilhaft, wenn die Gebläse an der Trennwand befestigt sind.

Herstellungsmäßig ergeben sich besonders einfache Verhältnisse, wenn das Plattenpaket aus zwei seitlich aneinanderliegend abgedichteten, miteinander verbundenen Teilplattenpaketen besteht, deren dem Außenluftstrom zugeordnete Kanäle durch entsprechende fluchtende Öffnungen an den aneinanderstoßenden Seiten miteinander verbunden sind und an den nebeneinanderliegenden Stirnseiten der Teilplattenpakete sich öffnen, wobei die den beiden Innen-Teilluftströmen zugeordneten Kanäle auf den gegenüberliegenden Stirnseiten sowie auf einander abgewandten Seitenflächen mündend ausgebildet sind. Zur Platzersparnis kann ein Teilplattenpaket eine geringere axiale Länge als das andere aufweisen und an ein zugeordnetes Gebläse abgedichtet angeschlossen sein.

Bei lösbar in das Einschubgehäuse eingesetzten Teilplattenpaketen ist es dabei vorteilhaft, wenn das Gebläse zwischen einer einen entsprechenden Luftdurchlaß aufweisenden Trennwand des Einschubgehäuses und dessen Vorderwand angeordnet ist.

Das ganze Einschub-Kühlgerät kann staub- und spritzwassergeschützt ausgebildet sein, ohne daß dazu ein besonderer konstruktiver Aufwand getrieben werden müßte.

In der Zeichnung ist ein Ausführungsbeispiel des Gegenstandes der Erfindung dargestellt. Es zeigen:

Fig. 1 ein Einschub-Kühlgerät gemäß der Erfindung, in einer Draufsicht,

Fig. 2 das Einschub-Kühlgerät nach Fig. 1, in einer
Seitenansicht auf die Vorderwand,

Fig. 3,4 das Einschub-Gerät nach Fig. 1, in einer
Seitenansicht, unter Veranschaulichung unterschiedlicher Strömungsverhältnisse,

Fig. 5 das Einschub-Kühlgerät nach Fig. 1, in einer
Draufsicht, bei abgenommenem Deckel,

Fig. 6 das Plattenpaket mit den zugeordneten Gebläsen
des Einschub-Kühlgerätes nach Fig. 1, in einer
perspektivischen Darstellung, unter Veranschaulichung der Luftführung für den Innen- und den
Außenluftstrom,

Fig. 7 das Einschub-Kühlgerät nach Fig. 1, in einer Seitenansicht, bei abgenommenem Deckel und teilweise herausgenommenem und geschnittenem Plattenpaket,

Fig. 8 das Einschub-Kühlgerät nach Fig. 1, in einer
Seitenansicht von vorne, bei abgenommener
Vorderwand, in einer Ansicht in der Richtung
VIII-VIII der Fig. 1, und

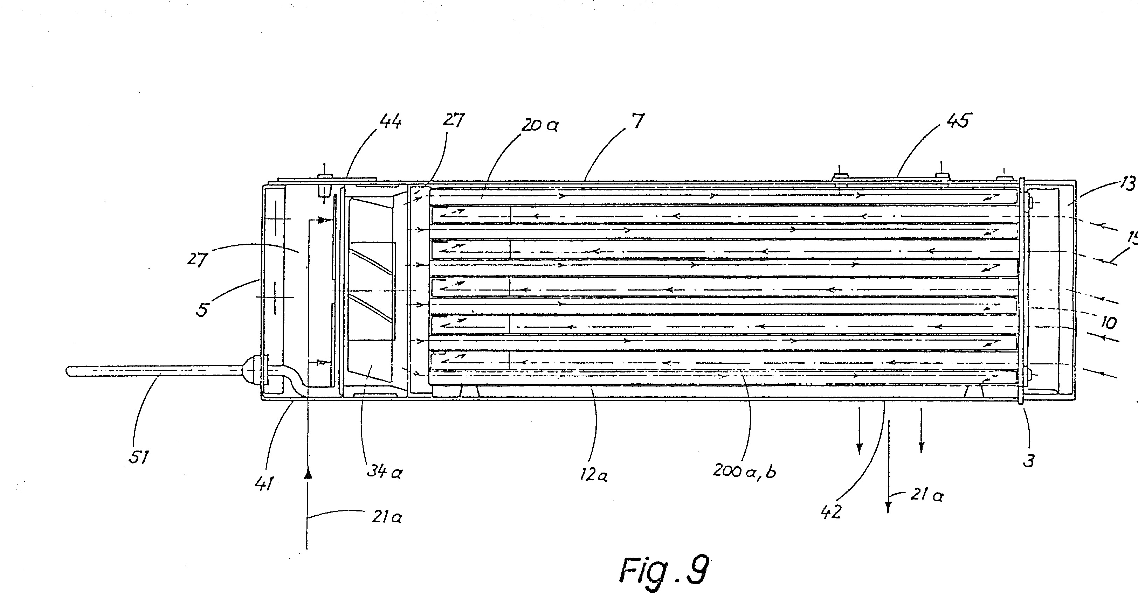

Fig. 9 das Einschub-Kühlgerät nach Fig. 1, geschnitten
längs der Linie IX-IX der Fig. 1, in einer
Seitenansicht.

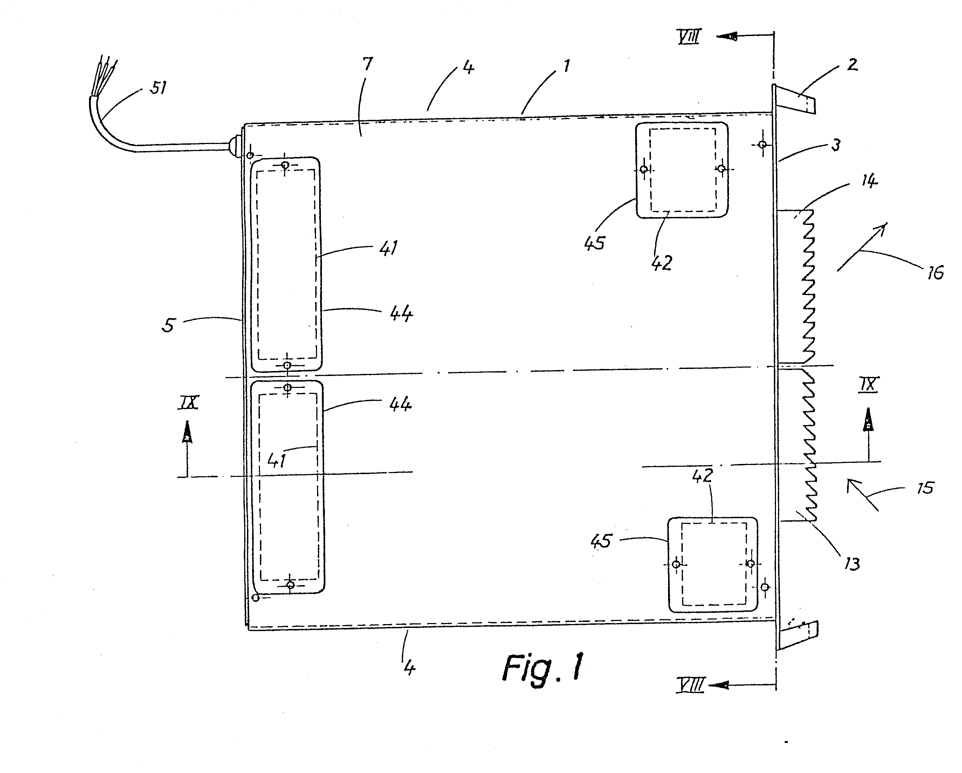

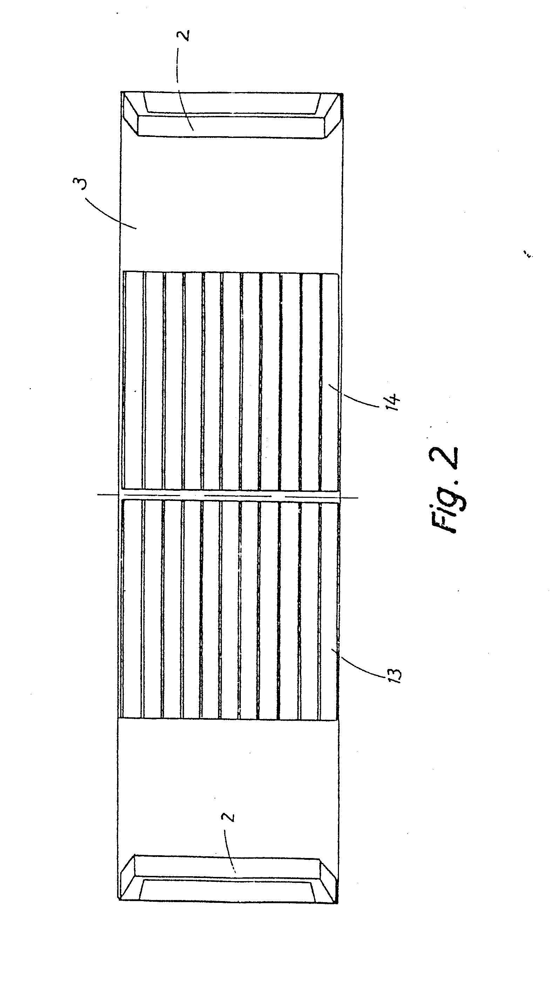

Das Einschub-Kühlgerät weist in der aus den Fig. 1 bis 4 ersichtlichen Weise ein im Querschnitt rechteckiges, flaches Einschubgehäuse 1 auf, das in Gestalt eines Blechgehäuses ausgebildet ist und dessen Außenabmessungen entsprechend dem Modul des zur Aufnahme von Modul-Einschüben eingerichteten Schaltschrankes gewählt sind. In der Praxis am weitesten verbreitet sind bei diesen sogenannten Intermaß-Schaltschränken die 19"-Einschübe.

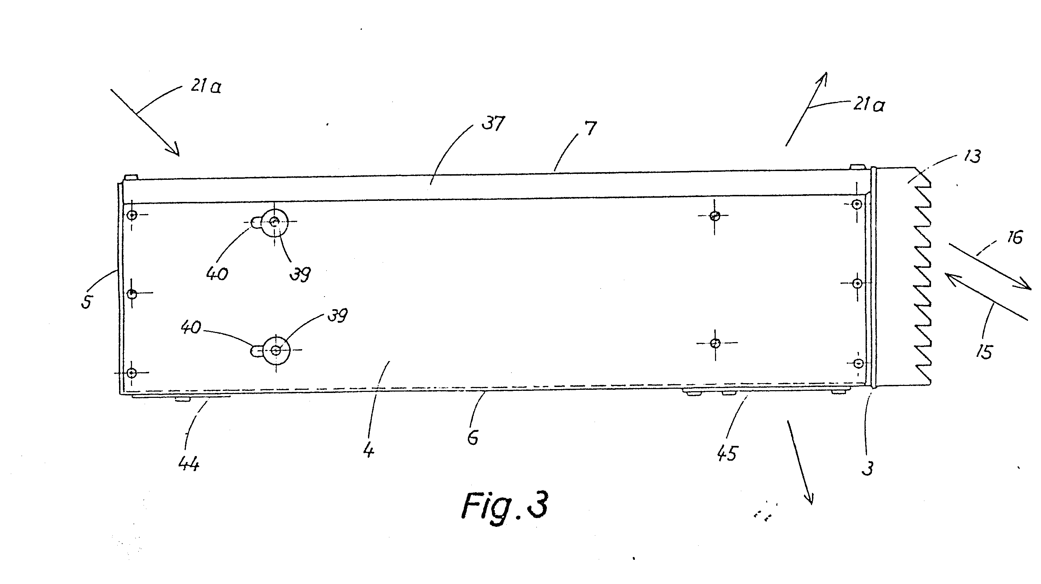

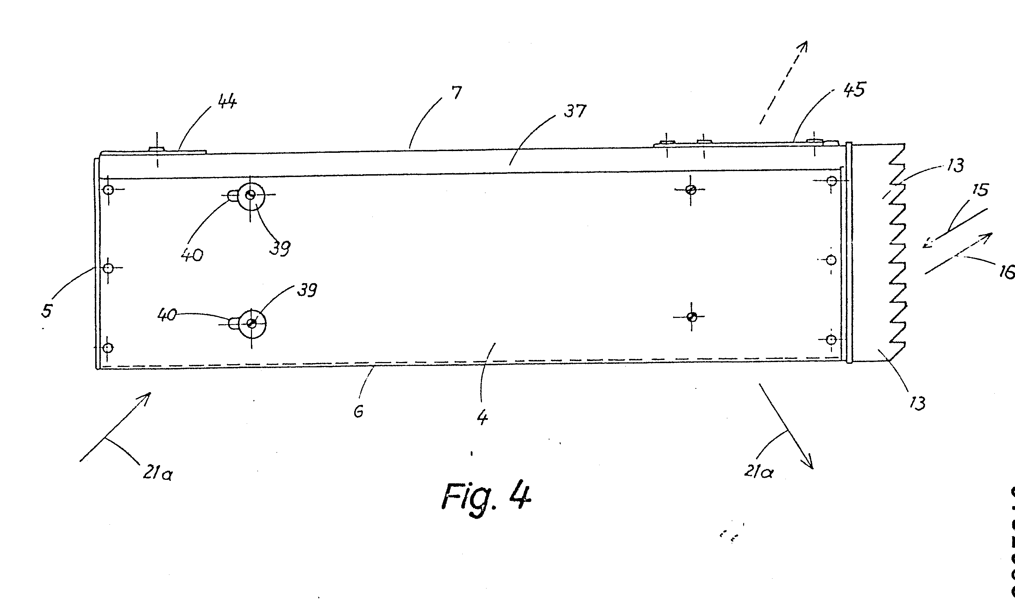

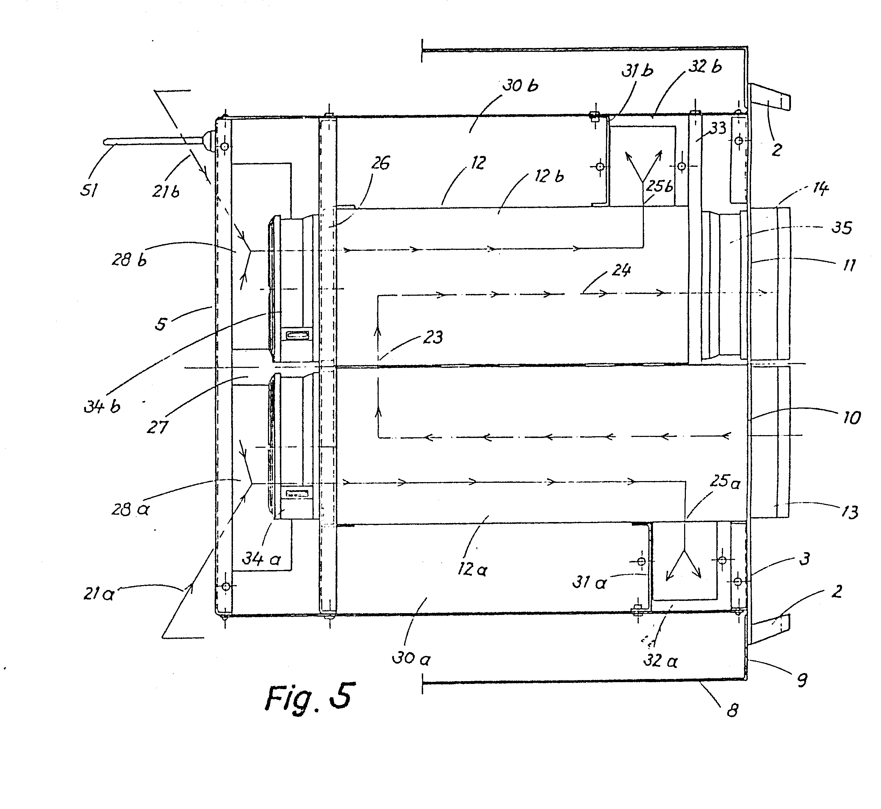

Das parallelflächig begrenzte Einschubgehäuse 1 besteht aus einer Handgriffe 2 tragenden Vorderwand 3, zwei Seitenwänden 4, einer Rückwand 5, einer Bodenwand 6 und einem in Gestalt eines lösbaren Deckels ausgebildeten Deckwand 7. In der Vorderwand 3, die bei in einen Schaltschrank 8 (Fig. 5) eingeschobenem Einschubgehäuse 1 an der Schaltschrankvorderwand 9 abgedichtet anliegt, sind nebeneinanderliegend eine Einlaßöffnung 10 und eine Auslaßöffnung 11 für einen Außenluftstrom vorgesehen, der eine in dem Einschubgehäuse 1 untergebrachte, im einzelnen noch zu erläuternde, als Plattenpaket 12 ausgebildete Wärmetauschereinrichtung durchströmt. Auf die Vorderwand 3 sind im Bereiche der Einlaß- und der Auslaßöffnung 10 bzw. 11 verstellbare Luftleiteinrichtungen aufgesetzt, die jeweils durch eine drehbar gelagerte Jalousie 13 bzw. 14 gebildet sind. Die beiden Jalousien 13,14 können von außen her so eingestellt werden, daß die bei 15 bzw. 16 durch Pfeile angedeutete Strömungsrichtung der zu- bzw. abströmenden Außenluft schräg nach unten (Fig. 3) oder schräg nach oben (Fig. 4) oder seitlich divergierend verläuft, wie dies für den jeweiligen Aufstellungsort des Schaltschrankes 8 zweckmäßig ist. Dabei kann die Anordnung auch derart getroffen sein, daß die zuströmende Außenluft bspw. schräg von oben kommt, während die abströmende warme Außenluft schräg nach unten oder zur Seite bläst, um nur eine weitere Einstellmöglichkeit der Jalousien 13,14 zu erwähnen.

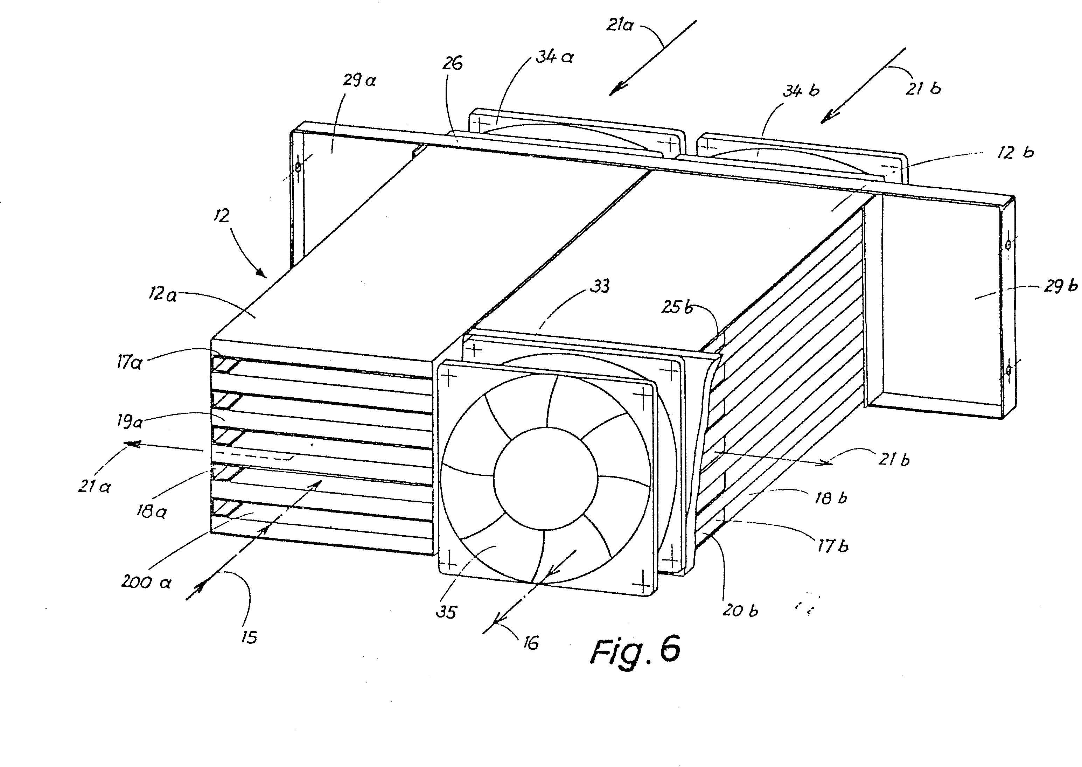

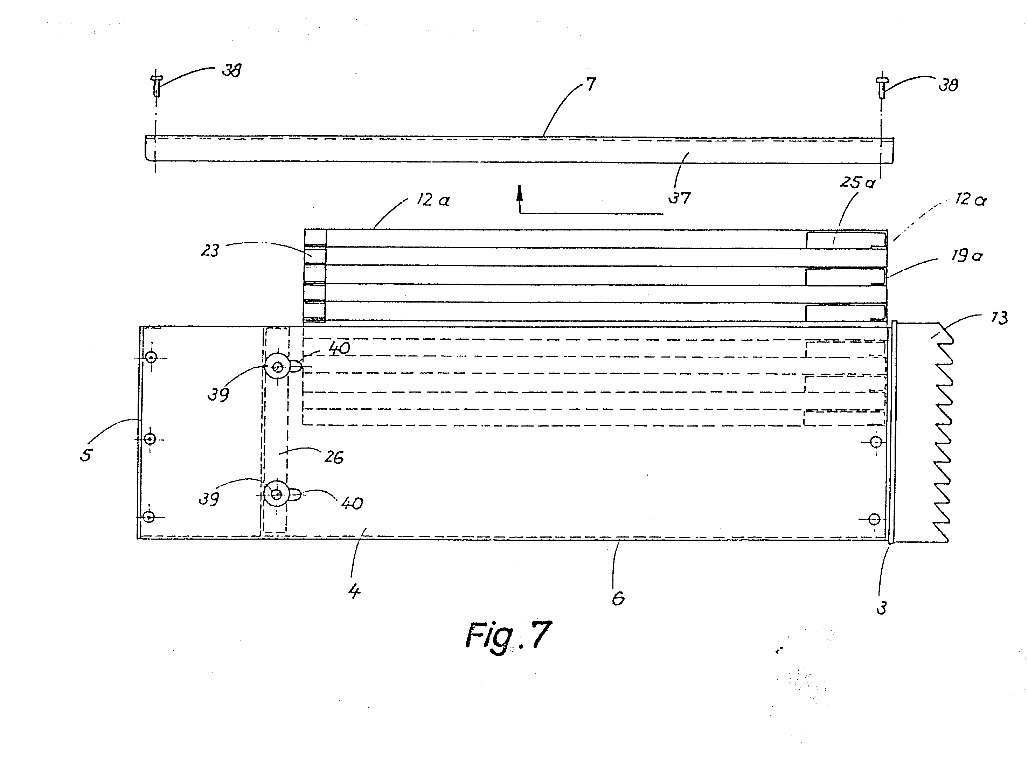

Das im Inneren des Einschubgehäuses 1 angeordnete Plattenpaket 12 besteht aus zwei Teilplattenpaketen 12a, 12b, von denen jedes aus einer Anzahl miteinander verklebter gleicher Platten 17a bzw. 17b zusammengesetzt ist, die jeweils mit hochgebogenen seitlichen Rändern 18a bzw. 18b und einem an der Stirnseite hochgebogenen Rand 19a bzw. 19b (Fig.6, 7) versehen sind.

Der genaue Aufbau der Platten 17a bzw. 17b und deren gegenseitige Zuordnung sind aus der DE-PS 30 45 326 bekannt.

Zwischen den Platten 17a bzw. 17b sind jeweils flache Kanäle 20a bzw. 20b begrenzt, die bei jedem Teilplattenpaket 12a bzw. 12b von einem Teilluftstrom 21a bzw. 21b durchströmt sind, der im Inneren des Schaltschrankes 8 im Kreislauf geführt ist.

Die abwechselnd zwischen den mit der Innenluft beaufschlagten Kanälen 20a, 20b liegenden, von den Platten 17a, 17b begrenzten Kanäle 200 a,b sind von dem Außenluftstrom durchströmt, so daß sich über

- 12 -

die Platten 17a bzw. 17b hinweg ein kurzer Wärmeaustauschweg zwischen dem Innen- und den Außenluftstrom ergibt.

Die Anordnung ist dabei derart getroffen, daß die
beiden Teilplattenpakete 12a, 12b in der aus den
Fig. 5,6 ersichtlichen Weise an aneinanderstoßenden
Seitenflächen zu dem einheitlichen Plattenpaket 12 miteinander verklebt sind, wobei die von der
Außenluft durchströmten flachen Kanäle 200 a,b durch entsprechende, miteinander fluchtende Öffnungen im Bereiche der aneinanderstoßenden Seitenwände bei 23
(Fig. 5) abgedichtet miteinander verbunden sind. Die
Öffnungen 23 liegen im Abstand von der Vorderwand 3
anschließend an die Rückwand des Plattenpaketes 12.
Gleichzeitig öffnen sich diese Kanäle an der der
Vorderwand 3 des Einschubgehäuses 1 benachbarten
Stirnseite des Plattenpaketes 12, wo sie mit der
Lufteinlaß- bzw. Luftauslaßöffnung 10 bzw. 11
abgedichtet verbunden sind. Diese Kanäle sind deshalb von der Außenluft auf einem im wesentlichen
U-förmigen Strömungsweg 24 durchströmt, wie dies
aus Fig. 5 zu ersehen ist.

Die beiden Innen-Teilluftströme 21a, 21b treten in
die Kanäle 20a bzw. 20b der Teilplattenpakete 12a,
12b auf der der Vorderwand 3 abgewandten Stirnseite
ein; die zugeordneten Luftauslässe sind in der Nähe
der Vorderwand 3 auf gegenüberliegenden Seiten des
Plattenpaketes 12 angeordnet; sie sind mit 25a bzw.
25b bezeichnet.

Wie aus den Fig. 5,6 zu ersehen, sind die Innen-
Teilluftströme 21a, 21b über den größten Teil der Länge des Plattenpaketes 12 parallel zu der Außenluftströmung 24 gerichtet, wobei sie im Gleich-
oder im Gegenstrom geführt sein können.

In dem Einschubgehäuse 1 sind durch eine in der Nähe
der Gehäuserückwand 5 angeordnete Trennwand 26 und
eine Querwand 27 zwei Kammern 28a, 28b abgeteilt,
die Luftkanäle bilden, welche sich über seitliche
Rahmenöffnungen 29a, 29b (Fig. 6) bei 30a bzw. 30b
auch seitlich des Plattenpaketes 12 erstrecken. Sie
sind endseitig durch Wände 31a bzw. 31b gegen ebenfalls seitlich des Plattenpaketes 12 angeordnete
Luftkanäle 32a, 32b abgedichtet, in die ihrerseits
die Innenluft-Auslässe 25a, 25b der Teilplattenpakete
12a, 12b münden.

Auf der gegenüberliegenden Seite ist der Luftkanal
32a durch eine Trennwand 33 begrenzt, die sich über
die Breite des benachbarten Teilplattenpaketes 12b
erstreckt, das eine geringere axiale Länge als das
andere Teilplattenpaket 12a aufweist. Das Teilplattenpaket 12b ist stirnseitig mit seinen der Außenluft
zugeordneten Kanälen abgedichtet an die Trennwand 33
angeschlossen.

Der andere Luftkanal 32 b ist auf der der Wand 31b
gegenüberliegenden Seite durch die Vorderwand 3
verschlossen; im übrigen sind die Luftkanäle 32a,
32b, ebenso wie die Kammern 28a, 28b, durch die
Bodenwand 6, jeweils eine Seitenwand 4 bzw. die
Rückwand 5 und die Deckwand 7 begrenzt.

In der Kammer 28a und der Kammer 28b ist jeweils ein Axialgebläse 34a bzw. 34b angeordnet, das
auf die Trennwand 26 abgedichtet aufgesetzt ist
und von denen das eine den Teilluftstrom 21a und
das andere den Teilluftstrom 21b erzeugt. Zur Erzeugung des Außenluftstromes dient ein Axialgebläse 35, das abgedichtet zwischen der einen entsprechenden Luftdurchlaß aufweisenden Trennwand
33 und der Vorderwand 3 angeordnet ist.

Für den Fall, daß eine höhere Strömungsgeschwindigkeit des Außenluftstromes erforderlich sein sollte,
könnte die Trennwand 33 auch ähnlich der Trennwand
26 über die ganze Breite des Einschubgehäuses 1
durchgeführt sein, wobei bei entsprechend verkürztem
Teilplattenpaket 12a ein weiteres Gebläse in ähnlicher Weise wie das Gebläse 35 dem anderen Teilplattenpaket 12a stirnseitig vorgeschaltet wäre.

Das Plattenpaket 12 ist in das Einschubgehäuse 1
lösbar eingesetzt. Es ist stirnseitig zwischen den
beiden Trennwänden 26, 33 und der Vorderwand 3
abgedichtet gehaltert und kann nach Lösen eines,
das ganze Einschubgehäuse 1 abdeckenden, die
Deckwand 7 bildenden Deckels 37 in der aus Fig. 7
ersichtlichen Weise aus dem Einschubgehäuse 1
herausgenommen werden. Der Deckel 37 ist mit dem
Einschubgehäuse 1 über Schrauben 38 verbunden,
während die Trennwand 26 an den Gehäuseseitenwänden 4 begrenzt längsverschieblich über
Schrauben 39 befestigt ist, die mit Längsschlitzen
40 in der Gehäuseseitenwand 4 zusammenwirken.

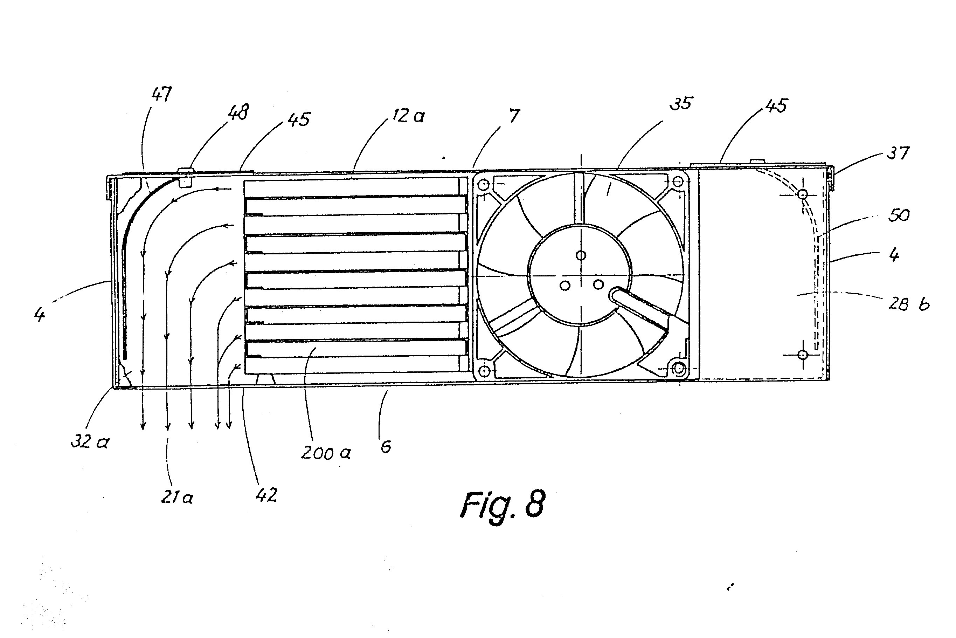

In der Deckwand 7 und der Bodenwand 6, sowie gegebenenfalls in den Seitenwänden 4, sind mit den Kammern 28a, 28b bzw. den Luftkanälen 32a, 32b in Verbindung stehende Gehäuseöffnungen 41, 42 angeordnet, von denen in den Fig. 3,4 die in der Bodenwand 6 bzw. der Deckwand 7 vorgesehenen Gehäuseöffnungen 41, 42 durch lösbar aufgeschraubte Deckel 44 bzw. 45 verschlossen sind. Mit den Deckeln 45 sind dabei etwa viertelkreisförmig gekrümmte Luftleitbleche 47 bei 48 (Fig. 8) verschraubt, die in die Luftkanäle 32a, 32b ragen und durch die die aus den Luftauslässen 25a, 25b austretenden Teilluftströme strömungsgünstig nach unten zu umgelenkt werden, so daß sie im wesentlichen rechtwinklig aus den in der jeweiligen Wand vorgesehenen Gehäuseöffnungen 42 austreten. Ähnliche Luftleitbleche können auch in den Kammern 28a, 28b angeordnet sein, wie dies in Fig. 8 bei 50 gestrichelt angedeutet ist.

Das ganze Einschubgehäuse 1 ist somit bei aufgeschraubtem Deckel 37 staub- und spritzwassergeschützt; es entspricht zumindest der Schutzart IP 54. Es kann einfach in einen Schaltschrank an der für einen Einschub vorgesehenen Stelle auf den zugehörigen Teleskopschienen eingeschoben werden, wobei das bei 51 angedeutete elektrische Anschlußkabel für die Elektromotoren der Gebläse 34a, 34b und 35 an eine geeignete Stromquelle angeschlossen wird. Durch entsprechende Wahl der offengelassenen bzw. durch einen Deckel 44 bzw. 45 verschlossenen Gehäuseöffnungen 41 bzw. 42 kann jeder der Innen-Teilluftströme wahlweise

so gerichtet werden, daß er an dem Einschubgehäuse 1 oben, unten, seitlich oder an der rückwärtigen Stirnseite ein- bzw. austritt und deshalb optimal auf die zugeordnete Wärmequelle ausgerichtet ist. Das Einschub-Kühlgerät ist deshalb universell einsetzbar und durch einfache Wahl der jeweils geeigneten Innenlufteinlaß- bzw. Auslaßöffnungen an den vorliegenden Einsatzfall in einfacher Weise anpaßbar.

Das Plattenpaket 12 weist im wesentlichen der Einschubhöhe entsprechende Höhenabmessungen auf, so daß das Einschubgehäuse 1 mit nur wenigen Höheneinheiten (HE), bspw. 3HE, ausgeführt werden kann.

Bei dem im Vorstehenden beschriebenen Ausführungsbeispiel sind die Gebläse 34a, 34b derart angeordnet und ausgebildet, daß die erwärmte Innenluft im hinteren Bereich des Schaltschrankes angesaugt und im vorderen Bereich des Schaltschrankes gekühlt ausgeblasen wird.

Abhängig von der Bestückung des Schaltschrankes mit wärmeerzeugenden Bauelementen sind auch Fälle denkbar, bei denen es vorteilhafter ist, die erwärmte Innenluft vorne abzusaugen und im hinteren Bereich gekühlt auszublasen.

Dies läßt sich ohne weiteres dadurch erreichen, daß die Gebläse 34a, 34b einfach um 180° gedreht eingesetzt werden. Damit werden die Teilluftströme des Innenkreislaufs nicht mehr durch die Teilplattenpakete 12a, 12b gedrückt, sondern gesaugt. Eine Beeinträchtigung der Wärmetauscherleistung ist damit nicht verbunden. Da es sich bei den Gebläsen 34a, 34b um Axialgebläse handelt, kann die Durchströmrichtung der Teilplattenpakete 12a, 12b in der beschriebenen Weise einfach umgekehrt werden, ohne daß dazu der Austausch der Gebläse oder andere bauliche Veränderungen an dem Einschub-Kühlgerät erforderlich wären.

- 18 -

Patentansprüche
-----------------

1. Einschub-Kühlgerät für zur Aufnahme von Modul-Einschüben eingerichtete Schaltschränke, mit einem im wesentlichen parallelflächig begrenzten Einschubgehäuse, das einen Außenluftauslaß und an seiner Vorderseite einen Außenlufteinlaß aufweist und in dem eine von einem Innenluftstrom und einem Außenluftstrom durchströmte Wärmetauschereinrichtung angeordnet ist, wobei der Innen- und der Außenluftstrom im dem Einschubgehäuse voneinander getrennt geführt und beiden Luftströmen in dem Einschubgehäuse untergebrachte Gebläse zugeordnet sind, dadurch gekennzeichnet, daß der Innen- und der Außenluftstrom in dem Einschubgehäuse (1) durch einen gemeinsamen Wärmetauscher geführt sind, der aus einer Anzahl zu einem abgeschlossenen Plattenpaket (12) zusammengefügter gleicher Platten (17a, 17b) mit hochgebogenen seitlichen Rändern (18a, 18b) und einem an der Stirnseite hochgebogenen Rand (19a, 19b) besteht, zwischen denen abwechselnd von der Innen- und der Außenluft durchströmte flache Kanäle (20a, 20b; 200a, 200b) begrenzt sind, daß das Plattenpaket (12) im wesentlichen der Einschubhöhe entsprechende Höhenabmessungen aufweist und in dem Einschubgehäuse (1) seitlich des Plattenpaketes (12) dem Innenluftstrom zugeordnete Luftkanäle (28a, 28b, 30a, 30b; 32a, 32b) angeordnet sind, die über wahlweise benutzbare Gehäuseöffnungen (41,42) mit dem Schaltschrankinneren in Verbindung setzbar sind.

2. Einschub-Kühlgerät nach Anspruch 1, dadurch gekennzeichnet, daß das Plattenpaket (12) in das Einschubgehäuse (1) lösbar eingesetzt ist.

3. Einschub-Kühlgerät nach Anspruch 1 oder 2, dadurch gekennzeichnet, daß an der Vorderseite des Einschubgehäuses (1) eine Einlaß- und eine Auslaßöffnung (10 bzw. 11) nebeneinanderliegend angeordnet sind, die jeweils abgedichtet mit den entsprechenden Kanälen des Plattenpaketes (12) verbunden sind.

4. Einschub-Kühlgerät nach Anspruch 3, dadurch gekennzeichnet, daß auf das Einschubgehäuse (1) im Bereiche der Einlaß- und/oder der Auslaßöffnung (10 bzw. 11) jeweils eine verstellbare Luftleiteinrichtung (13,14) aufgesetzt ist, durch die die zu- bzw. abströmende Außenluft wahlweise in eine gewünschte seitliche Richtung ablenkbar ist.

5. Einschub-Kühlgerät nach Anspruch 4, dadurch gekennzeichnet, daß die Luftleiteinrichtung eine drehbar gelagerte, die jeweilige Öffnung (10, 11) überdeckende Jalousie (13,14) ist.

6. Einschub- Kühlgerät nach einem der Ansprüche 3 bis 5, dadurch gekennzeichnet, daß durch entsprechende Ausbildung der Kanäle (20a, 20b; 200a, 200b) in dem Plattenpaket (12) der Außenluftstrom im wesentlichen U-förmig (24) zwischen der Einlaß- und der Auslaßöffnung (10, 11) verlaufend geführt ist und daß der Innenluftstrom in zwei getrennte Teilluftströme (21a, 21b) aufgeteilt ist, von denen jedem ein eigenes Gebläse (34a, 34b) zugeordnet ist.

7. Einschub-Kühlgerät nach Anspruch 6, dadurch gekennzeichnet, daß die beiden Teilluftströme (21a, 21b) nebeneinander verlaufend stirnseitig in zugeordnete Kanäle (20a, 20b) des Plattenpaketes (12) eintretend oder aus diesen austretend geführt sind und ihnen an gegenüberliegenden Seiten des Plattenpaketes (12) angeordnete Luftaus- bzw. -einlässe (25a, 25b) zugeordnet sind, die in Luftkanäle (32a, 32b) des Einschubgehäuses (1) münden.

8. Einschub-Kühlgerät nach Anspruch 7, dadurch gekennzeichnet, daß gegebenenfalls insbesondere verstellbare Luftumlenkeinrichtungen (47) enthaltende Luftkanäle (32a, 32b) beidseitig des Plattenpaketes (12) liegend angeordnet sind und daß die zugeordneten Gehäuseöffnungen (42) in der Ober-, Unter- oder Seitenwand (7,6,5) des Einschubgehäuses (1) wahlweise verschließbar ausgebildet sind.

9. Einschub-Kühlgerät nach Anspruch 7 oder 8, dadurch gekennzeichnet, daß dem Plattenpaket (12) in dem Einschubgehäuse (1) stirnseitig von den Teilluftströmen durchströmte Luftkanäle (28a, 28b) vorgeschaltet sind und daß die zugeordneten Gehäuseöffnungen (41) in der Ober-, Unterseiten- oder Stirnwand (7,6,4,5) des Einschubgehäuses (1) wahlweise verschließbar ausgebildet sind.

10. Einschub-Kühlgerät nach Anspruch 9, dadurch gekennzeichnet, daß in dem Einschubgehäuse (1) durch eine

Luftdurchlässe aufweisende Trennwand (26) eine Luftkanäle bildende unterteilte Kammer (28a, 28b) abgeteilt ist, in der die den Teilluftströmen zugeordneten Gebläse (34a, 34b) angeordnet sind und die durch einen Gehäuseöffnungen (41, 42) enthaltenden lösbaren Deckel (37) abgeschlossen ist.

11. Einschub-Kühlgerät nach den Ansprüchen 2 und 10, dadurch gekennzeichnet, daß das Plattenpaket (12) zwischen der Trennwand (26) und der Vorderwand (3) und/oder einer zweiten Trennwand (33) des Einschubgehäuses (1) stirnseitig jeweils abgedichtet angeschlossen gehaltert ist.

12. Einschub-Kühlgerät nach Anspruch 10 oder 11, dadurch gekennzeichnet, daß wenigstens eine Trennwand (26, 33) in dem Einschubgehäuse (1) begrenzt längsverschieblich befestigt ist.

13. Einschub-Kühlgerät nach einem der Ansprüche 10 bis 12, dadurch gekennzeichnet, daß die Gebläse (34a, 34b; 35) an der Trennwand (26; 33) befestigt sind.

14. Einschub-Kühlgerät nach einem der Ansprüche 6 bis 13, dadurch gekennzeichnet, daß das Plattenpaket (12) aus zwei seitlich aneinanderliegend, abgedichtet miteinander verbundenen Teilplattenpaketen (12a, 12b) besteht, deren dem Außenluftstrom zugeordnete Kanäle (200a, 200b) durch entsprechende fluchtende Öffnungen (23) miteinander verbunden sind und an den nebeneinanderliegenden Stirnseiten der Teilplattenpakete (12a, 12b) sich öffnen und daß die den beiden Innenteilluftströmen (21a, 21b) zugeordneten Kanäle (20a, 20b) auf den gegenüberliegenden Stirnseiten sowie auf einander abgewandten Seitenflächen mündend ausgebildet sind.

15. Einschub-Kühlgerät nach Anspruch 14, dadurch gekennzeichnet, daß ein Teilplattenpaket (12b) eine geringere axiale Länge als das andere (12a) aufweist und an ein zugeordnetes Gebläse (35) abgedichtet angeschlossen ist.

16. Einschub-Kühlgerät nach den Ansprüchen 2 und 15, dadurch gekennzeichnet, daß das Gebläse (35) zwischen einer einen entsprechenden Luftdurchlaß aufweisenden Trennwand (33) des Einschubgehäuses (1) und dessen Vorderwand (3) angeordnet ist.

17. Einschub-Kühlgerät nach einem der vorhergehenden Ansprüche, dadurch gekennzeichnet, daß es staub- und spritzwassergeschützt ausgebildet ist.

Fig.1

0152093

Fig. 2

Fig. 3

*Fig. 4*

0152093

*Fig. 5*

*Fig. 6*

0152093

0152093

Fig.7

Fig. 8

Fig.9

0152093